# EUROPÄISCHE PATENTSCHRIFT

(11) **EP 3 000 139 B1**
(45) Veröffentlichungstag und Bekanntmachung des Hinweises auf die Patenterteilung: **26.04.2017**
(21) Anmeldenummer: 14726949.2
(22) Anmeldetag: 23.05.2014
(51) Int. Cl.: H01L 41/27, H01L 41/293

(54) **VERFAHREN UND VORRICHTUNG ZUR HERSTELLUNG EINES ELASTOMERSTAPELAKTORS**
METHOD AND DEVICE FOR PRODUCING AN ELASTOMER STACK ACTUATOR
PROCÉDÉ ET DISPOSITIF DE FABRICATION D'UN ACTIONNEUR MULTI-COUCHE À BASE D'ÉLASTOMÈRE

(30) Priorität: 23.05.2013 EP 13168855; 07.06.2013 EP 13170988
(43) Veröffentlichungstag der Anmeldung: 30.03.2016
(73) Patentinhaber: Parker Hannifin Corporation, Cleveland, OH 44124 (US)
(72) Erfinder: SCHMEER, Holger, 50674 Köln (DE); FELLER, Torsten, 42369 Wuppertal (DE); DEGIORGIO, Nicolas, 47807 Krefeld (DE); CLAUBERG, Karin, 42657 Solingen (DE); NOWAK, Stephan, 50827 Köln (DE)
(74) Vertreter: Cohausz & Florack
(86) Internationale Anmeldenummer: PCT/EP2014/060705
(87) Internationale Veröffentlichungsnummer: WO 2014/187976

(56) Entgegenhaltungen:
- WO-A1-2005/086249
- WO-A1-2009/112988
- WO-A2-2014/074554

## Beschreibung

Die Erfindung betrifft ein Verfahren zum Herstellen eines Elastomer basierten Folienstapelaktors umfassend einen Startprozess, einen Stapelprozess und einen Finalisierungsprozess. Darüber hinaus betrifft die Erfindung einen durch das Verfahren hergestellten Folienstapelaktor und eine Vorrichtung zum Herstellen eines Elastomer basierten Folienstapelaktors.

Kunststoffverbundstoffe werden in einer Vielzahl von Anwendungen eingesetzt. Beispielsweise wird ein entsprechender Schichtverbund als Verpackungsmaterial, Isolationsmaterial oder als Konstruktionsmaterial verwendet. Neben diesem herkömmlichen Einsatzzweck werden Schichtverbunde vermehrt als aktive Komponenten in Generatoranwendungen, Sensoranwendungen oder Aktuatoranwendungen bzw. Aktoranwendungen eingesetzt.

So ist es bekannt, ein elektroaktives Material, wie ein dielektrisches Elastomer, zwischen zwei Elektroden anzuordnen, um einen Aktor und/oder Sensor herzustellen. Als elektroaktive Polymere werden Polymere bezeichnet, die auf eine elektrische Stimulation ihre physikalischen Eigenschaften ändern. Der Aufbau der Aktoren entspricht dem eines Plattenkondensators. Aktoren werden somit zumindest aus einem elastischen Dielektrikum und zwei nachgiebigen, vorzugsweise parallel und gegenüberliegend angeordneten Elektroden gebildet. Wird eine Spannung an die elektrisch leitfähigen Elektroden angelegt, so verursacht das durch die Spannung erzeugte elektrische Feld eine Kontraktion des Dielektrikums in Feldrichtung und gleichzeitig eine Vergrößerung der Aktorfläche senkrecht zur Feldrichtung.

Wie jeder elektromechanische Wandler bzw. Aktor kann ein dielektrischer Polymeraktor auch als Sensor betrieben werden. Dies erfolgt über die messbare elektrische Kapazitätsänderung unter Einfluss einer mechanischen Kraft, die eine Deformation des Aktors bzw. Sensors verursacht.

Allgemein lässt sich feststellen, dass dielektrische Elastomere mit einer möglichst hohen Feldstärke (nahe der Durchschlagfeldstärke des Dielektrikums) betrieben werden können/sollten. Die Betriebsspannung dieser Aktoren hängt hierbei von der Schichtdicke des Dielektrikums ab. Sie kann beispielsweise zwischen 100 V und 20 kV, beispielsweise im Bereich von 600 V, liegen. Dies ermöglicht sehr hohe Energiedichten und geringe Reaktionszeiten, die im Millisekunden Bereich oder weniger liegen können. Das mechanische Verhalten der dielektrischen Elastomeraktoren ist ebenfalls von der Betriebsspannung abhängig. Da eine geringe Betriebsspannung wünschenswert ist, ist es ein stetiges Anliegen, die Dicke der dielektrischen Elastomerfolie zu reduzieren.

Eine Möglichkeit zur Vergrößerung der Aktorkräfte bzw. der Kapazität der dielektrischen Elastomere besteht darin, die Aktoren übereinander zu stapeln. Die gestapelten Einzelaktoren können elektrisch parallel geschaltet sein. Aufgrund der Parallelschaltung der Einzelaktoren wird die Elektrodenfläche, also die aktive Fläche, vervielfacht und somit auch die maximal erreichbare mechanische Rückmeldung. So ist es beispielsweise vorstellbar, zwischen 40 und 400 Einzelaktoren übereinander zu stapeln, um einen so genannten Stapelaktor herzustellen. Ein Stapelaktor zeichnet sich demnach dadurch aus, dass eine Mehrzahl von Einzelaktoren übereinander gestapelt und vorzugsweise parallel geschaltet ist.

Die Herstellung von Stapelaktoren gestaltet sich jedoch schwierig. Grundsätzlich sind aus dem Stand der Technik zwei Herstellungsvarianten, die Nass- und Trocken- Deposition der verwendeten Materialien, bekannt. Während bei der Nass-Deposition die jeweiligen Schichten als flüssiger Film aufgetragen werden und so miteinander reagieren können, werden in dem Trocken-Depositionsverfahren die einzelnen Folienlagen aufeinander laminiert.

In der EP 2 136 419 A2 werden ein monolithischer Vielschichtaktor bzw. Stapelaktor sowie ein Nass-Depositionsverfahren zum Herstellen eines monolithischen Vielschichtaktors beschrieben. Dabei werden die einzelnen Schichten miteinander vernetzt. Die einzelnen Materialien werden so aufeinander eingestellt, dass sie in Folge einer chemischen Verkettungsreaktion miteinander reagieren. Ein Vorteil in dem beschriebenen Nass-Depositionsverfahren ist die Vermeidung von Delaminationseffekten der einzelnen Schichten. Jedoch ist das Verfahren kaum für eine automatische und effiziente Fertigung einer Vielzahl von Stapelaktoren geeignet.

Bei einem Trocken-Depositionsverfahren wird in einem Stapelungsprozess eine Mehrzahl von vorzugsweise Elastomer-Schichten übereinander gestapelt, indem eine mit Elektroden versehene Folie auf eine weitere Folie auflaminiert wird. Elastomer-Schichten, insbesondere Polyurethan-Schichten, sind besonders für elektroaktive Anwendungen geeignet. Auf die hergestellte Folienanordnung kann dann eine weitere Schicht Elektroden aufgetragen und eine weitere Folie auflaminiert werden, usw.

Problematisch bei den aus dem Stand der Technik bekannten Trocken-Depositionsverfahren ist insbesondere die Handhabung von besonders dünnen Elastomer-Schichten, wie Polyurethan-Schichten, im Bereich zwischen ca. 10 µm und ca. 200 µm. Neben der geringen Dicke gestaltet sich die Verarbeitung insbesondere aufgrund der klebrigen Eigenschaften der Polyurethan-Schichten schwierig. Ferner ist bei der gleichzeitigen Herstellung einer Mehrzahl von Stapelaktoren die genaue Positionierung der verschiedenen Schichten und/oder Elektroden problematisch. WO 2009/112988 A1 lehrt ein Verfahren zur Herstellung von Elastomer-Stapelaktoren basierend auf einer kontinuierlichen Rolle zu Rolle Laminierung mit intermittierendem Aufbringen der Elektrodenschichten.

Insgesamt ist aus dem Stand der Technik somit kein Verfahren oder Vorrichtung zur Herstellung eines Folienstapelaktors bekannt, welches eine effiziente Herstellung erlaubt, die insbesondere für eine industrielle Fertigung eingesetzt werden kann.

Daher liegt der vorliegenden Erfindung die Aufgabe zugrunde, ein Verfahren zum Herstellen eines Elastomer basierten Folienstapelaktors sowie eine Vorrichtung zum Herstellen eines Elastomer basierten Folienstapelaktors zur Verfügung zu stellen, welche/s in effizienter Weise die Herstellung des Folienstapelaktors ermöglicht.

Die zuvor hergeleitete und aufgezeigte Aufgabe wird gemäß einem ersten Aspekt der Erfindung bei einem Verfahren nach Patentanspruch 1 gelöst. Das Verfahren zum Herstellen eines Elastomer basierten Folienstapelaktors, insbesondere eines Polyurethan basierten Folienstapelaktors, umfasst:
a) einen Startprozess mit den Schritten:
   a1) Bereitstellen einer Elastomer-Folie mit einer Elastomer-Schicht und zwei Deckschichten in Form einer Kaschierungsschicht und einer Linerschicht, und
   a2) Entfernen von einer der zwei Deckschichten von der Elastomer-Folie zur Herstellung einer dekaschierten Folienanordnung,
b) einen dem Startprozess nachfolgenden Stapelprozess mit den Schritten:
   b1) Aufbringen einer Schicht von Elektroden auf die Elastomer-Schicht der dekaschierten Folienanordnung,
   b2) Auflaminieren einer weiteren dekaschierten Elastomer-Folie auf die mit Elektroden versehene Folienanordnung, und
   b3) Entfernen von einer der zwei Deckschichten von der laminierten Folienanordnung zur Herstellung einer dekaschierten Folienanordnung,
   wobei in dem Stapelprozess b) die Schritte b1) bis b3) mindestens einmal wiederholt werden, und
   wobei dem wiederholten Schritt b1) die in dem vorherigen Schritt b3) erzeugte dekaschierte Folienanordnung als dekaschierte Folienanordnung bereitgestellt wird,
c) einen dem Stapelprozess nachfolgenden Finalisierungsprozess mit den Schritten:
   c1) Kontaktieren der Elektroden der durch den Stapelungsprozess erzeugten Folienanordnung,
   c2) Vereinzeln von Stapelaktoren der durch den Stapelungsprozess erzeugten Folienanordnung, und
   c3) Verkapseln der vereinzelten Stapelaktoren.

Indem im Gegensatz zum Stand der Technik die zu verarbeitende Folie bzw. Folienanordnung während des Stapelungsprozess stets mindestens eine Deckschicht in Form einer Linerschicht oder Kaschierungsschicht aufweist, kann ein effizientes Herstellungsverfahren bereitgestellt werden. Insbesondere können in effizienter Weise klebrige und besonders dünne Elastomer-Schichten (insbesondere < 200 µm) verarbeitet werden.

Das erfindungsgemäße Trocken-Depositionsverfahren umfasst im Wesentlichen drei Prozesse: einen Startprozess, einen Stapelprozess und einen Finalisierungsprozess.

In dem Startprozess wird eine Elastomer-Folie bereitgestellt. Beispielsweise kann eine Elastomer-Folie mit vorgebbaren Maßen insbesondere in Form eines Elastomer-Folien-Bogens bereitgestellt werden. Die Maße sind insbesondere von den eingesetzten Verarbeitungseinheiten bzw. - maschinen abhängig. Die Elastomer-Folie weist eine Elastomer-Schicht und zwei Deckschichten, eine Kaschierungsschicht und eine Linerschicht, auf. Die Elastomer-Schicht, welche insbesondere eine Dicke von ca. 10 µm bis 200 µm aufweisen kann, kann zwischen der Kaschierungsschicht, beispielsweise eine Polyethylenschicht (PE-Schicht), und der Linerschicht, wie eine Papierlinerschicht, angeordnet sein. Mit anderen Worten sind die beiden Oberflächen der insbesondere klebrigen Elastomer-Schicht mit Deckschichten versehen.

Eine Elastomer-Folie kann bevorzugt aus einem Material ausgewählt aus der Gruppe umfassend Polyurethan-Elastomere, Silikon-Elastomere und/oder Acrylat-Elastomere sein. Insbesondere kann die Elastomer-Schicht ausgewählt aus der Gruppe umfassend Polyurethan-Elastomere, Silikon-Elastomere und/oder Acrylat-Elastomere sein. Besonders bevorzugt ist die Elastomer-Folie eine Polyurethan-Folie (PU-Folie) mit einer Polyurethan-Schicht (PU-Schicht) und zwei Deckschichten.

Unter einem Elastomer ist vorliegend stets ein dielektrisches Elastomer zu verstehen, wie eine dielektrische Elastomer-Folie, eine dielektrische Elastomer-Schicht oder ein dielektrischer Elastomer basierter Folienstapelaktor.

Zur Vorbereitung des dem Startprozess nachfolgenden Stapelprozesses kann die Elastomer-Folie dekaschiert werden. Vorzugsweise wird die Kaschierungsschicht entfernt. Indem nur eine der zwei Deckschichten entfernt wird, kann die Elastomer-Folie in nachfolgenden Verarbeitungsschritten in einfacher Weise weiterverarbeitet werden. So kann durch die vorzugsweise weiterhin vorhandene Linerschicht die dekaschierte Elastomer-Folie beispielsweise über Rollen weitergeleitet und nachfolgenden Verarbeitungsstationen zugeführt werden.

Die dekaschierte Elastomer-Folie wird in dem Stapelprozess wie folgt weiterverarbeitet. Zunächst kann auf die dekaschierte Oberfläche der Elastomer-Folie, also auf die Elastomer-Schicht, eine Schicht mit Elektroden aufgebracht werden. Insbesondere können eine Vielzahl von Elektroden aufgebracht werden, um eine parallele Fertigung einer Vielzahl von Stapelaktoren zu ermöglichen.

In einem nachfolgenden Laminierungsschritt wird auf die mit der Elektrodenschicht versehene Elastomer-Schicht eine weitere dekaschierte Elastomer-Folie aufgebracht. Insbesondere weist die bereitgestellte weitere Elastomer-Folie eine Elastomer-Schicht und als Deckschicht eine Linerschicht auf. Die weitere Elastomer-Folie wird derart auflaminiert, dass die Elastomer-Schicht unmittelbar die Elektrodenschicht kontaktiert. Das Ergebnis dieser Laminierung ist insbesondere eine Anordnung umfassend eine untere Deckschicht, vorzugsweise in Form Linerschicht, eine darauf angeordnete Elastomer-Schicht, eine darauf angeordnete Elektrodenschicht, eine darauf angeordnete Elastomer-Schicht und eine darauf angeordnete Deckschicht, vorzugsweise in Form einer Linerschicht.

In einem dem Laminierungsschritt nachfolgenden Dekaschierungsschritt wird eine der zwei Deckschichten, wie eine Linerschicht, entfernt, während die andere Deckschicht, wie eine Linerschicht, an der laminierten und dekaschierten Folienanordnung verbleibt. Mit anderen Worten liegt eine Elastomer-Schicht der Folienanordnung nach Durchführung der Dekaschierung frei. Indem nur eine der zwei Deckschichten entfernt wird, kann diese Elastomer-Folienanordnung in nachfolgenden Verarbeitungsschritten in einfacher Weise weiterverarbeitet werden.

Die dekaschierte Folienanordnung wird dann vorzugsweise als Ausgangsprodukt für die Wiederholung der Schritte b1) bis b3) verwendet. Mit anderen Worten wird auf die freiliegende PU-Schicht vorzugweise eine weitere Elektrodenschicht aufgebracht, auf die Elektrodenschicht dann eine weitere dekaschierte Elastomer-Folie auflaminiert und anschließend (genau) eine Deckschicht von der laminierten Folienanordnung mit nun zwei Elektrodenschichten und drei Elastomer-Schichten entfernt. Die Schritte b1) bis b3) werden vorzugsweise so oft wiederholt, bis ein Stapelaktor die gewünschte Anzahl an übereinander gestapelter Einzelaktoren (z.B. 10 bis 1000) aufweist.

Nachdem die Folienanordnung mit der gewünschten Anzahl an übereinander gestapelter Einzelaktoren hergestellt wurde, kann nach Schritt b3) die hergestellte Folienanordnung dem Finalisierungsprozess zugeführt werden.

In dem Finalisierungsschritt können die Elektroden kontaktiert und die Stapelaktoren vereinzelt werden. Hierbei kann vorgesehen sein, dass zunächst die Elektroden kontaktiert und anschließend die Stapelaktoren vereinzelt werden oder die Stapelaktoren zunächst vereinzelt und anschließend die Elektroden der vereinzelten Stapelaktoren kontaktiert werden. Insbesondere können die Einzelaktoren eines Stapelaktors parallel geschaltet sein.

In einem weiteren Schritt werden die vereinzelten Stapelaktoren insbesondere zum Schutz vor ungewünschten Umgebungseinflüssen verkapselt. In effektiver Weise können eine Vielzahl von Stapelaktoren im Wesentlichen parallel hergestellt werden.

Gemäß einer ersten Ausführungsform des erfindungsgemäßen Verfahrens kann in einem Schritt a3) des Startprozesses a) die Elastomer-Folie zugeschnitten werden. Beispielsweise kann mittels einer Schneidstation ein Elastomer-Folie-Bogen mit vorgebbaren Maßen hergestellt werden. Das Zuschneiden der Elastomer-Folie kann vorzugsweise vor dem Entfernen einer Deckschicht, wie der Kaschierungsschicht, erfolgen. Wird bei einer alternativen Variante der Erfindung die Elastomer-Folie nach dem Entfernen der Kaschierungsschicht zugeschnitten, so muss sichergestellt werden, dass die Elastomer-Schicht bzw. frei von Staub oder andere Partikeln bleibt.

Darüber hinaus kann vorzugsweise das Aufbringen der Elektroden auf die Elastomer-Schicht ein Aufbringen von strukturierten Elektroden umfassen. Die strukturierten Elektroden können durch einen Siebdruckprozess, einen Tiefdruckprozess, einen Flexodruckprozess und/oder ein Sprühverfahren aufgebracht werden. In einfacher Weise und insbesondere mit einer exakten Positionierung kann eine Elektrodenschicht mit einer Vielzahl von Elektroden auf die Elastomer-Schicht aufgebracht werden. Es kann eine strukturierte bzw. segmentierte Schicht gebildet werden. Ferner kann gemäß einer bevorzugten Ausführungsform eine Elektrode aus einem Material gebildet sein, das ausgewählt ist aus der Gruppe umfassend Metalle, Metalllegierungen, leitfähige Oligo-oder Polymere, leitfähige Oxide, Kohlenstoffe und/oder mit leitfähigen Füllstoffen gefüllte Polymere.

Gemäß der vorliegenden Erfindung werden die Elektroden in alternierenden Schritten b1) jeweils mit einem Versatz zwischen 0,2 mm und 2,0 mm aufgebracht. Um in einem nachfolgenden Kontaktierungsschritt die Kontaktierung in einfacher Weise zu ermöglichen, werden die Elektroden in abwechselnden Schritten b1) mit einem Versatz aufgebracht. Durch den Versatz kann insbesondere für jede Elektrode eine Anschlusskontaktfläche erzeugt werden. In einfacher Weise können die gestapelten Aktoren in einem nachfolgenden Kontaktierungsschritt parallel geschaltet werden.

Das Kontaktieren der Vielzahl von Elektroden eines Aktors kann grundsätzlich in beliebiger Weise erfolgen. Gemäß einer bevorzugten Ausführungsform kann das Kontaktieren der Elektroden das Erzeugen von Hohlräumen an oder in Anschlusskontaktflächen der Elektroden umfassen. Beispielsweise können die Hohlräume durch einen Stanz- und/oder Schneidprozess erzeugt werden. Die erzeugten Hohlräume können zur Kontaktierung der Elektroden mit einer leitfähigen Paste gefüllt werden. Insbesondere kann dieser Kontaktierungsprozess vor dem Vereinzeln der Aktoren erfolgen. Beispielsweise können die Hohlräume für sämtliche Stapelaktoren eines PU-Folien-Bogens parallel erzeugt werden. Eine weitere Verbesserung der Effizienz des Herstellungsverfahrens wird erzielt.

Für den Fall, dass eine leitfähige Paste zur Kontaktierung Verwendung findet, ist es gemäß einer weiteren Ausführungsform bevorzugt, wenn die leitfähige Paste zumindest aus einem chemisch ähnlichen Material wie der Stapelaktor, vorzugsweise aus dem gleichen Material wie die Stapelaktor, gebildet ist. Indem die Kontaktierungsmasse aus einem zumindest chemisch ähnlichen Material wie der Stapelaktor, insbesondere dem Elektrodenmaterial, hergestellt ist, kann die Kontaktierungsmasse mit dem Stapelaktor eine monolithische Verbindung eingehen. Somit kann insbesondere die Lebensdauer der Kontaktierung signifikant erhöht werden.

Bei einer alternativen und bevorzugten Ausführungsform können die Stapelaktoren vereinzelt werden, derart, dass Stirnflächen der Anschlusskontaktflächen der Elektroden freiliegen. An die freiliegenden Anschlusskontaktflächen kann ein elektrischer Leiter zur Kontaktierung der Elektroden angebracht werden. Mit anderen Worten werden die Stapelaktoren bei dieser Kontaktierungsart zunächst vereinzelt. Wie nachfolgend ausgeführt wird, ist zur Vereinzelung das Ultraschallschneiden besonders geeignet. Die Stapelaktoren werden derart vereinzelt, dass Stirnflächen der Elektroden, wie die Stirnflächen der Anschlusskontaktflächen der Elektroden, freiliegen. Die einzelnen Elektroden eines Aktors werden anschließend mit Leitern versehen, um die freiliegenden Stirnflächen der Elektroden zu kontaktieren. Die freiliegenden Stirnenden können bei einer bevorzugten Ausführungsform mittels eines Siebprozesses kontaktiert werden. Insbesondere kann ein elektrischer Leiter zur Kontaktierung der freiliegenden Stirnenden der Elektroden mittels eines Siebdruckprozesses aufgebracht werden.

In einer besonders bevorzugten Ausführungsform kann der elektrische Leiter mittels eines Gießprozesses angegossen werden. Beispielsweise kann der vereinzelte Stapelaktor in eine Gießform gesetzt werden. Anschließend kann in besonders einfacher und sicherer Weise die Kontaktierung der Elektroden hergestellt werden. Die Erzeugung von Hohlräumen und deren Füllung mit einer leitfähigen Paste kann entfallen. Vorzugsweise kann die Füllung von Hohlräumen mittels eines Gießprozesses erfolgen. Der Folienbogen mit einer Mehrzahl von mit Hohlräumen versehenen Stapelaktoren kann hierzu beispielsweise in einer Gießform eingesetzt werden.

Wie bereits beschrieben wurde, wird gemäß einer bevorzugten Ausführungsform vorgeschlagen, dass das Vereinzeln der Aktoren mittels eines Ultraschallprozesses durchgeführt wird. Zwar ist es grundsätzlich denkbar, auch andere Techniken, wie Laserschneiden, Vibrationsschneiden und/oder Stanzen, zu verwenden. Jedoch ist erkannt worden, dass durch ein Ultraschallschneiden besonders saubere Schnittkanten erzielt werden. Indem saubere Schnittkanten erzeugt werden, können die Elektroden derart freigelegt werden, dass sie sicher und einfach kontaktiert werden können. Ferner kann bevorzugt auch das Zuschneiden der Elastomer-Folie mittels eines Ultraschallprozesses durchgeführt werden.

Darüber hinaus ist gemäß einer weiteren erfindungsgemäßen Ausführungsform vorgesehen, dass die vereinzelten Aktoren durch Eingießen mit einem insbesondere ein niedriges E-Modul aufweisenden Material, insbesondere Silikon oder Polyurethan, verkapselt werden können. Durch eine Verkapselung kann der Stapelaktor vor äußeren Einflüssen geschützt werden. Ein Silikon hat bessere feuchtigkeitsabweisende Eigenschaften als PU. Der Vorteil von PU liegt insbesondere darin, dass das PU-Verkapselungsmaterial eine monolithische Verbindung mit dem Stapelaktor eingehen kann, sofern als Elastomer PU eingesetzt wird. Dies hat zur Folge, dass es nur zu geringen Verlusten bei der Übertragung der Kraft führen wird. Das eingesetzte Material hat ferner bevorzugt einen sehr niedrigen E-Modul derart, dass die Auslenkung des Aktors nicht verhindert wird.

Die Verkapselung kann grundsätzlich in beliebiger Weise durchgeführt werden. Gemäß einer bevorzugten Ausführungsform kann das Verkapseln der Stapelaktoren mittels einer Verkapselungsform durchgeführt werden. Die Verkapselungsform kann mittels eines 2K-Dosiersystems befüllt werden. In besonders einfacher Weise kann eine gute Verkapselung erzielt werden. Insbesondere kann eine Verkapselungsform verwendet werden, welche eine parallele Verkapselung von einer Mehrzahl von Stapelaktoren erlaubt. Die Effizienz des vorliegenden Verfahrens kann weiter gesteigert werden.

Ein weiterer Aspekt ist ein Elastomer basierter, insbesondere Polyurethan basierter Folienstapelaktor hergestellt durch ein zuvor beschriebenes Verfahren.

Eine dielektrische Elastomerschicht, insbesondere PU-Schicht, weist vorzugsweise eine relativ hohe Dielektrizitätszahl (z.B. 4 bis 10 F·m⁻¹) auf. Darüber hinaus weist eine dielektrische Elastomerschicht vorzugsweise eine geringe mechanische Steifigkeit auf, um Bewegungen zu zulassen. Eine dielektrische Elastomerschicht kann insbesondere für eine Aktoranwendung eingesetzt werden. Jedoch eignen sich dielektrische Elastomerschicht ebenso für Sensoranwendungen.

Eine Elektrode wird durch eine elektrisch leitfähige Schicht gebildet. Vorzugsweise kann die eine PU-Schicht an ihren beiden Oberflächen mit einer leitfähigen Schicht unmittelbar kontaktiert, beispielsweise beschichtet, sein. Es versteht sich, dass die Unterseite bzw. die Oberseite der PU-Schicht nur teilweise bzw. abschnittsweise mit einer elektrisch leitfähigen Schicht beschichtet sein kann. Insbesondere kann eine strukturierte bzw. segmentierte Schicht gebildet werden.

Ein weiterer Aspekt der Erfindung ist eine Vorrichtung gemäß Patentanspruch 11. Die Vorrichtung zum Herstellen eines Elastomer basierten Folienstapelaktors, insbesondere Polyurethan basierten Folienstapelaktors, umfasst eine Startprozessanordnung. Die Startprozessanordnung umfasst eine erste Dekaschierungsstation eingerichtet zum Entfernen einer Deckschicht von einer bereitgestellten Elastomer-Folie zur Herstellung einer dekaschierten Folienanordnung. Die bereitgestellte Elastomer-Folie umfasst eine Elastomer-Schicht und zwei Deckschichten in Form einer Kaschierungsschicht und einer Linerschicht. Die Vorrichtung umfasst eine der Startprozessanordnung nachfolgende Stapelprozessanordnung. Die Stapelprozessanordnung umfasst eine Aufbringstation eingerichtet zum Aufbringen einer Schicht von Elektroden auf die Elastomer-Schicht der dekaschierten Folienanordnung. Die Stapelprozessanordnung umfasst eine Laminierungsstation eingerichtet zum Auflaminieren einer weiteren dekaschierten Elastomer-Folie auf die mit Elektroden versehene Folienanordnung. Die Stapelprozessanordnung umfasst eine zweite Dekaschierungsstation eingerichtet zum Entfernen von einer von zwei Deckschichten von der laminierten Folienanordnung zur Herstellung einer dekaschierten Folienanordnung. Die Stapelprozessanordnung ist eingerichtet, die durch die zweite Dekaschierungsstation erzeugte dekaschierte Folienanordnung entweder der Aufbringstation oder einer nachfolgenden Finalisierungsprozessanordnung zuzuführen. Die Vorrichtung umfasst die der Stapelprozessanordnung nachfolgenden Finalisierungsprozessanordnung. Die Finalisierungsprozessanordnung umfasst eine Kontaktierungsstation eingerichtet zum Kontaktieren der Elektroden der durch die zweite Dekaschierungsstation erzeugten dekaschierten Folienanordnung. Die Finalisierungsprozessanordnung umfasst eine Vereinzelungsstation eingerichtet zum Vereinzeln von Stapelaktoren der durch die zweite Dekaschierungsstation erzeugten dekaschierten Folienanordnung. Die Finalisierungsprozessanordnung umfasst eine Verkapselungsstation eingerichtet zum Verkapseln der vereinzelten Stapelaktoren.

Die Vorrichtung ist insbesondere zur Durchführung des oben beschriebenen Verfahrens eingerichtet.

Gemäß einer ersten Ausführungsform der erfindungsgemäßen Vorrichtung kann die Startprozessanordnung eine Zuschnittstation eingerichtet zum Zuschneiden der bereitgestellten Elastomer-Folie oder der dekaschierten Folienanordnung umfassen. Es kann in einfacher Weise, beispielsweise mittels eines Ultraschallprozesses oder eines anderen Schneidprozesses, ein Elastomer-Folien-Bogen mit Maßen bereitgestellt werden, welche für die nachfolgenden Verarbeitungsstationen geeignet ist.

Darüber hinaus kann gemäß einer bevorzugten Ausführungsform der erfindungsgemäßen Vorrichtung vorgesehen sein, dass die Kontaktierungsstation eine Kontaktierungseinrichtung zum Kontaktieren der Elektroden aufweist. Die Kontaktierungseinrichtung kann ein Absaugteil eingerichtet zum Absaugen des bei der Erzeugung eines Hohlraums entstehenden Butzens aufweisen. Die Kontaktierungseinrichtung kann ein Zuleitungsteil eingerichtet zum Dosieren der leitfähigen Paste in den erzeugten Hohlraum aufweisen. Indem die Kontaktierungsstation eine Kontaktierungseinrichtung aufweist, welche die Erzeugung von Hohlräumen, beispielsweise durch Stanzen, das gleichzeitige Absaugen des Butzens und die anschließende Füllung des erzeugten Hohlraums mit einer leitfähigen Paste erlaubt, kann die eine Mehrzahl von Schritten umfassende Kontaktierung durch das gleiche Werkzeug in effizienter Weise durchgeführt werden.

Es gibt nun eine Vielzahl von Möglichkeiten, das erfindungsgemäße Verfahren, den erfindungsgemäßen Stapelaktor und die erfindungsgemäße Vorrichtung auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines Ablaufdiagramms bzw. einer Vorrichtung eines Ausführungsbeispiels gemäß der vorliegende Erfindung,
- Fig. 2: eine schematische Querschnittsansicht eines Ausführungsbeispiels einer PU-Folie,
- Fig. 3: eine schematische Draufsicht eines Ausführungsbeispiels einer mit Elektroden versehenen Folienanordnung,
- Fig. 4: eine schematische Ansicht eines Ausführungsbeispiel der Laminierungsstation und zweiten Dekaschierungsstation,
- Fig. 5: eine schematische Querschnittsansicht eines Ausführungsbeispiels einer dekaschierten Folienanordnung,
- Fig. 6a: eine schematische Draufsicht eines ersten Ausführungsbeispiels eines Stapelaktors,
- Fig. 6b: eine schematische Querschnittsansicht des in Fig. 6a dargestellten Stapelaktors,
- Fig. 6c: eine schematische Draufsicht eines weiteren Ausführungsbeispiels eines Stapelaktors,
- Fig. 7: eine schematische Ansicht eines Ausführungsbeispiels einer Kontaktierungseinrichtung, und
- Fig. 8: eine schematische Ansicht eines beispielhaften Kräfteverlaufs in einem verkapselten Stapelaktors.

Nachfolgend werden gleiche Bezugszeichen für gleiche Elemente verwendet. Ferner wird in den nachfolgenden bevorzugten Ausführungsbeispielen die Herstellung eines PU-basierten Folienstapelaktors unter Verwendung von PU-Folien beschrieben. Es versteht sich, dass als Elastomermaterial anstelle von PU auch ein anderes Elastomermaterial eingesetzt werden kann.

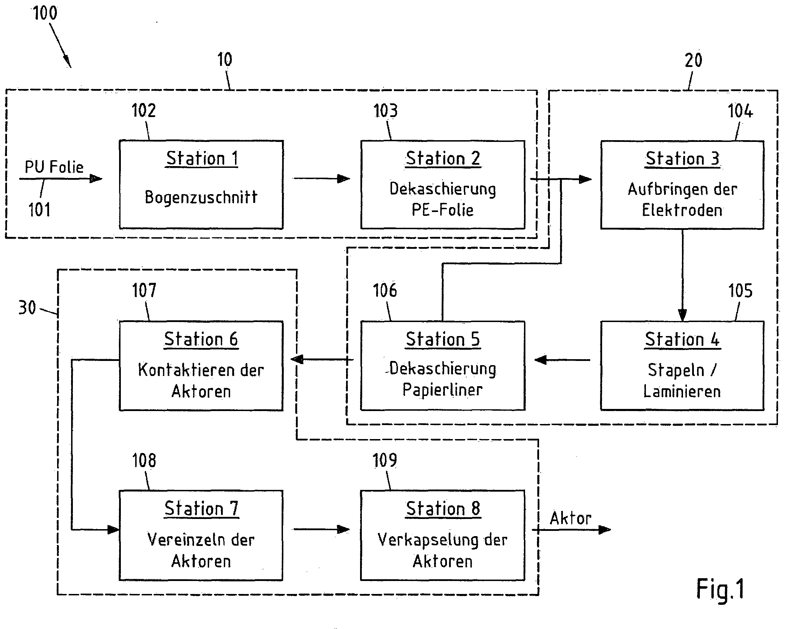

Figur 1 zeigt eine schematische Ansicht eines Ablaufdiagramms 100 bzw. einer beispielhaften Vorrichtung 100 gemäß der vorliegenden Erfindung.

Die Vorrichtung 100 umfasst eine Startprozessanordnung 10, eine Stapelprozessanordnung 20 und eine Finalisierungsprozessanordnung 30.

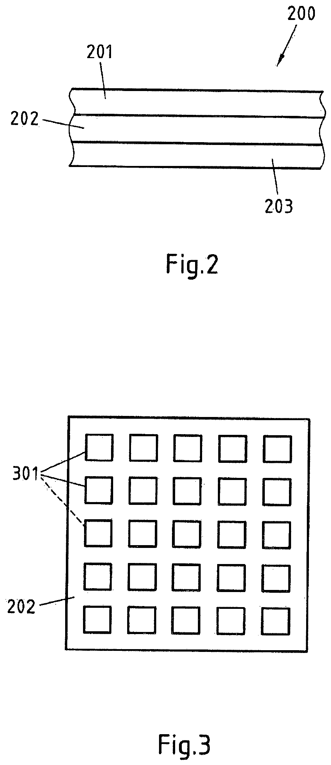

Zunächst kann in einem ersten Schritt 101 eine Polyurethan-Folie 200 bereitgestellt werden. Eine beispielhafte und bevorzugte Ausführungsform der bereitgestellten Polyurethan-Folie 200 ist in Figur 2 dargestellt.

Figur 2 zeigt eine schematische Schnittansicht einer Polyurethan-Folie 200. Die Polyurethan-Folie 200 umfasst im Wesentlichen drei Schichten 201, 202, 203. Die mittlere Schicht 202 ist eine Polyurethan-Schicht 202. Aufgrund der hohen Klebeigenschaften dieser Schicht 202, wird zur Vereinfachung der weiteren Verarbeitung die Polyurethan-Folie 200 mit zwei Deckschichten 201, 203 bereitgestellt. Auf die Polyurethan-Schicht 202 ist vorliegend eine obere Deckschicht 201 in Form einer Kaschierungsschicht 201, insbesondere eine Polyethylenschicht 201 (PE-Schicht), angebracht. Unterhalb der Polyurethan-Schicht 202 ist eine weitere Deckschicht 203 in Form einer Linerschicht 203, wie eine Papier-Linerschicht 203, angeordnet.

Für den Fall, dass die Polyurethan-Folie 200 nicht bereits mit gewünschten Maßen zur Verfügung gestellt wird, kann die Polyurethan-Folie 200 in einem Schritt 102 mittels einer Bogenzuschnittstation 1 bzw. Zuschnittstation 1 auf die gewünschten Maße zugeschnitten werden. Die insbesondere kontinuierlich bereitgestellten Polyurethan-Folie-Bögen 200 können in einem automatisierten Prozess auf die gewünschte Größe zugeschnitten werden.

Die zugeschnittene Polyurethan-Folie 200 bzw. der Polyurethan-Folie-Bogen 200 kann dann einer ersten Dekaschierungsstation 2 zugeführt werden. In einem ersten Dekaschierungsschritt 103 kann eine der zwei Deckschichten 201, 203, vorzugsweise die Kaschierungsschicht 201, wie eine Polyurethan-Schicht (PE-Schicht), entfernt werden. Wird die PE-Schicht 201 vor dem Bogenzuschnittschritt 102 entfernt, muss darauf geachtet werden, dass die Elastomerschicht bzw. Polyurethan-Schicht 202 frei von Staub und/oder anderen Partikeln bleibt. Das Papier muss so getrennt werden, dass Papierfasern vermieden werden.

Die dekaschierte Polyurethan-Folie 200, also eine Folie umfassend die Polyurethan-Schicht 202 und eine Deckschicht 203 beispielsweise in Form einer Linerschicht 203, wird der Stapelprozessanordnung 20, insbesondere einer Aufbringstation 3 zugeführt. In einem Elektrodenaufbringungsschritt 104 kann mindestens eine Elektrode 301, vorzugsweise eine Schicht mit einer Mehrzahl von strukturierten Elektroden 301, aufgebracht werden. Die strukturierten Elektroden 301 werden vorzugsweise in einem Siebdruckprozess aufgebracht. Andere Prozesse zur insbesondere positioniergenauen Aufbringung von kleinen Strukturen sind denkbar. Hierrunter können insbesondere Tief- oder Flexodruck, aber auch ein Sprühverfahren fallen.

Figur 3 zeigt eine Draufsicht eines Ausführungsbeispiels einer mit Elektroden 301 versehenen Polyurethan-Schicht 202 bzw. Folienanordnung. Wie zu erkennen ist, sind eine Vielzahl von vorliegend quadratisch gebildeten Elektroden 301 aufgebracht worden. Wie aus Figur 3 entnommen werden kann, werden mehrere Stapelaktoren gleichzeitig hergestellt. Die Anordnung bzw. die Anzahl der Stapelaktoren bzw. Elektroden 301 kann insbesondere von der Größe des Polyurethan-Folie-Bogens 200 abhängen. Die Stapelaktoren können erst nach dem Laminationsschritt 105 in einer nachfolgend näher erläuterten Vereinzelungsstation 7 vereinzelt werden.

Die mit Elektroden 301 versehene Polyurethan-Folie 200 wird dann einer Laminierungsstation 4 zugeführt. Die Laminierungsstation 4 ist dazu eingerichtet, einen Laminierungsschritt 105 bzw. einen Stapelschritt 105 durchzuführen. Insbesondere wird eine weitere bereitgestellte, dekaschierte und insbesondere bereits zugeschnittene Polyurethan-Folie 401 auf die mit Elektroden versehene Polyurethan-Folie 200 bzw. Folienanordnung aufgebracht. Die weitere Polyurethan-Folie 401 entspricht in ihrem Aufbau der bereits in Figur 2 beschriebenen Polyurethan-Folie 200 mit nur noch einer Deckschicht, wie einer Linerschicht.

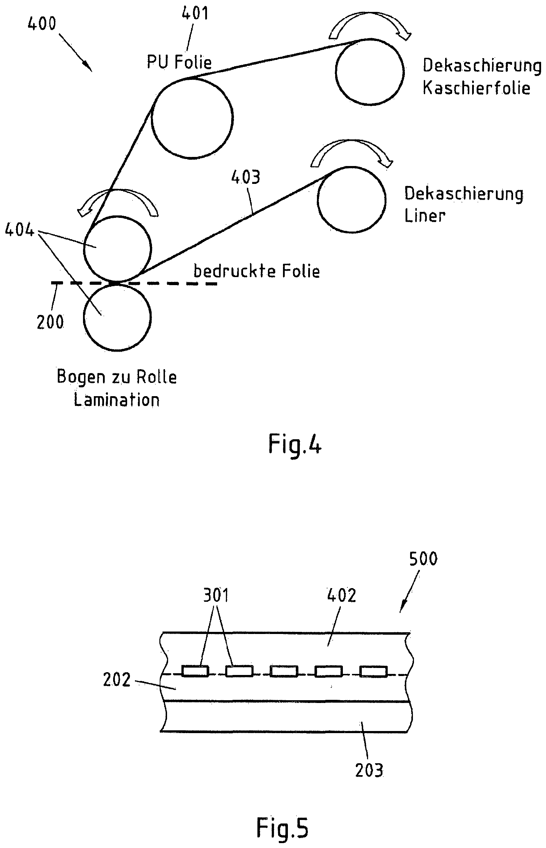

Figur 4 zeigt eine schematische Ansicht eines Ausführungsbeispiels einer Laminierungsstation 400 gemäß der vorliegenden Erfindung. Vor der Laminierung der weiteren Polyurethan-Folie 401 auf die mit Elektroden 301 versehenen, beispielsweise bedruckten Polyurethan-Folie 200, wird die weitere Polyurethan-Folie 401 dekaschiert. Mit anderen Worten wird insbesondere die Kaschierungsschicht von der Polyurethan-Folie 401 entfernt. Es versteht sich, dass alternativ auch die Linerschicht entfernt werden kann.

Wie bereits beschrieben wurde, wird vorliegend vor dem Laminierungsprozess die Kaschierfolie bzw. -schicht von dem PU-Elastomer 401 bzw. PU-Schicht abgezogen. Wie aus Figur 4 zu entnehmen ist, wird die dekaschierte Folie 401 von der Rolle 404 bzw. Rollen 404 auf den mit Elektroden beschichteten Bogen laminiert. Nach dem Laminierungsprozess wird vorliegend der Liner 403 bzw. die Linerschicht 403 in einem automatischen Prozess von der laminierten Folienanordnung dekaschiert (zweiter Dekaschierungsschritt 106 in der zweiten Dekaschierungsstation 5).

Um einen quasi-monolithischen Aufbau der Schichten eines Stapelaktors zu erreichen, besteht an dieser Stelle die Möglichkeit, die Oberfläche des bedruckten Bogens 200 mittels Coronaentladung, Plasmaentladung und/oder Elektronenbestrahlung zu behandeln.

Ein Vorteil des vorliegenden Stapelprozesses bzw. der vorliegenden Stapelprozessanordnung 20 ist, dass eine hohe Positioniergenauigkeit gewährleistet werden kann. Die erste zur bedruckende Folie, auch der Läufer genannt, welche von der Startprozessanordnung 10 bereitgestellt wird, dient als Positioniergrundlage für die weiteren Elektrodenschichten. D.h. die Positionierung muss lediglich in einem Prozessschritt, in dem Druckschritt 104, erfolgen, da bei der Laminierung keine Genauigkeit erforderlich ist.

Figur 5 zeigt eine schematische Querschnittsansicht eines Ausführungsbeispiels einer dekaschierten Folienanordnung 500 nach dem zweiten Dekaschierungsschritt 106. Wie aus Figur 5 zu erkennen ist, umfasst die Folienanordnung 500 eine untere Deckschicht 203 in Form einer Linerschicht 203, eine Polyurethan-Schicht 202, eine Elektrodenschicht 302 umfassend eine Mehrzahl von Elektroden 301 und eine weitere Polyurethan-Schicht 402.

Die Schichtanordnung 500 kann erneut der Aufbringstation 3 zugeführt werden, um eine weitere Elektrodenschicht oberhalb der weiteren Polyurethan-Schicht 402 aufzubringen. Insbesondere können die Schritte 104, 105 und 106 beliebig oft wiederholt werden, um eine gewünschte Anzahl an Schichten herzustellen bzw. eine gewünschte Zahl an Einzelaktoren übereinander zu stapeln. In diesen Zusammenhang sei erwähnt, dass die Elektroden für den vorliegend beschriebenen "Rolle auf Bogen Laminierungsprozess" 105 alternierend aufgebracht werden müssen. Der Versatz kann zwischen 0,2 und 2,0 mm betragen.

Nachdem eine Schichtanordnung bzw. Folienanordnung mit der gewünschten Anzahl an gestapelten Einzelaktoren bzw. Schichten hergestellt worden ist, wird diese Anordnung der Finalisierungsprozessanordnung 30 zugeführt. Im vorliegenden Ausführungsbeispiel wird die Folienanordnung der Kontaktierungsstation 6 von der zweiten Dekaschierungsstation 5 zugeführt. Die Kontaktierungsstation 6 ist dazu eingerichtet, in einem Kontaktierungsschritt 107 die Elektroden 301 mit Kontakten zu versehen. Beispielsweise kann vorgesehen sein, Hohlräume an den Elektroden, insbesondere an den Anschlusskontaktflächen der Elektroden, zu erzeugen.

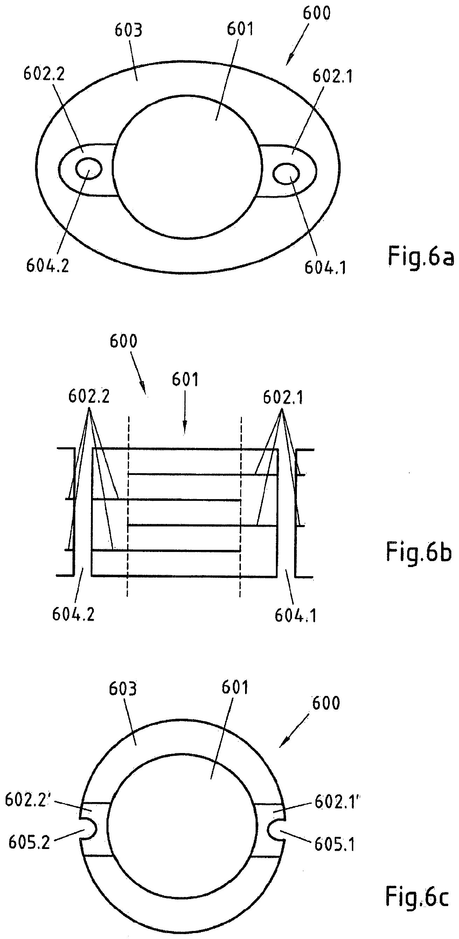

Eine beispielhafte Draufsicht auf einen gestapelten Aktor 600 mit Hohlräumen 604.1, 604.2 ist in Figur 6a gezeigt. Wie der Figur 6a zu entnehmen ist, weist der Stapelaktor 600 im Zentrum die Elektroden 601 auf, welche mit Anschlusskontaktflächen 602.1, 602.2 versehen sind. Insbesondere kann jede Elektrode mit einer Anschlusskontaktflächen 602.1, 602.2 versehen sein. Eine Schlusskontaktfläche und eine Elektrodenfläche bilden eine gemeinsame leitende Fläche. Beispielsweise können die Anschlusskontaktflächen 602.1, 602.2 durch die zuvor beschriebene alternierende Anordnung der Elektroden 601 mit einem Versatz bereitgestellt werden. Ferner ist mit Bezugszeichen 603 das PU-Material bezeichnet. Die Anschlusskontaktflächen 602.1, 602.2 sind mit jeweils einem Hohlraum 604.1, 604.2 versehen. Dieser kann beispielsweise durch einen Stanzprozess erzeugt worden sein.

Eine Schnittansicht des gestapelten Aktors 600 ist in Figur 6b gezeigt. Die aktiven Flächen 601 bzw. Elektroden 601 weisen jeweils eine Anschlusskontaktflächen 602.1, 602.2 auf. Insbesondere ist die Anordnung der Elektroden 601 mit einem Versatz zu erkennen. In den Anschlusskontaktflächen 602.1, 602.2 ist jeweils ein Hohlraum 604.1, 604.2 vorgesehen, welcher vorzugsweise mit einer elektrisch leitfähigen Paste gefüllt werden kann. Nach Befüllung sind sowohl die Anschlusskontaktflächen 602.1 miteinander verbunden als auch die Anschlusskontaktflächen 602.2.

Wie bereits beschrieben wurde, kann die Kontaktierung der Elektroden erfolgen, indem die Hohlräume 604.1, 604.2 im Stapelaktor 600 mit leitfähiger Paste befüllt werden. Der Hohlraum 604.1, 604.2 kann durch einen der in der Zuschnittstation 7 durchführbares Schneidverfahren hergestellt werden. Bevorzugt wird hier das Stanzen oder Ultraschallschneiden eingesetzt. Es versteht sich, dass neben einem kreisförmigen Querschnitt eines Hohlraums auch andere geometrische Formen möglich sind.

Der für die Durchkontaktierung der Schichten erzeugte Hohlraum 604.1, 604.2 kann mittels eines automatischen Dosiersystems, z.B. der Firma Vieweg, mit der leitfähigen Paste befüllt werden. Die Stapelaktoren befinden sich auf dem Einzelbogen, so dass eine Handhabung in dem Schritt vereinfacht wird. Nachdem alle Stapelaktoren kontaktiert sind, kann der komplette Bogen getempert werden, so dass die Kontaktierungspaste aushärten kann. Die Paste ist bevorzugt aus demselben, zumindest aus einem chemisch ähnlichen Material wie der Stapelaktor selbst, so dass die Kontaktierungsmasse mit dem Stapelaktor eine im Wesentlichen monolithische Verbindung eingehen kann. Somit kann die Lebensdauer der Kontaktierung deutlich erhöht werden.

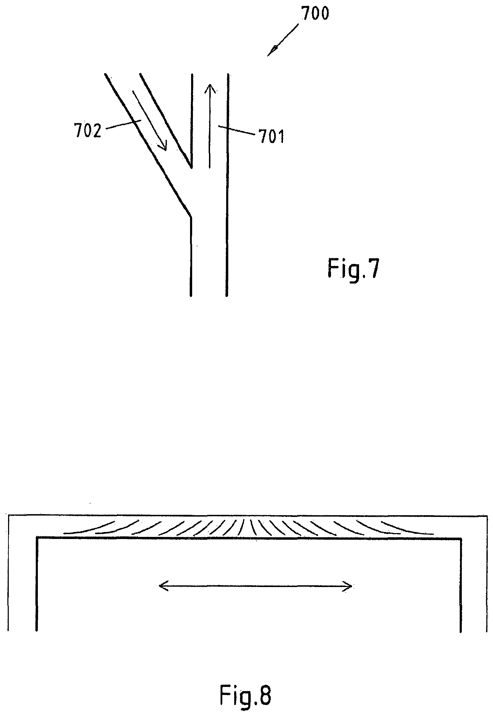

Vorzugsweise kann vorliegend eine Dosiereinheit 700 bzw. Kontaktierungseinrichtung 700, die die Folie bzw. die gestapelte Folienanordnung, durchbohrt und beim Herausziehen der Nadel 700 den Hohlraum füllt, zum Einsatz kommen (vgl. Figur 7). Dabei kann der Butzen über das Absaugteil 701 insbesondere während des Stanzens bzw. Durchbohrens abgesaugt und anschließend über ein Zuleitungsteil 702, wie durch eine zusätzliche Zuleitung 702, die leitfähige Paste dosiert werden.

Nach der Kontaktierung der Elektroden kann der Bogen umfassend eine Vielzahl von Stapelaktoren einer Vereinzelungsstation 7 zugeführt werden Die Vereinzelungsstation 7 ist dazu eingerichtet, die Stapelaktoren in einem Vereinzelungsschritt 108 zu vereinzeln. Aus den Einzelbögen können mittels geeigneter Schneidetechnik die Stapelaktoren vereinzelt werden. Geeignete Scheidetechniken können Ultraschall-, Laser- oder Vibrationsschneiden, aber auch ein Stanzprozess sein. Ultraschallschneiden ist bevorzugt, da erfindungsgemäß erkannt worden ist, dass hierdurch gute Schneidkanten und somit fehlerfreie Bauteile erzielt werden können.

Figur 6c zeigt eine weitere beispielhafte Draufsicht auf einen gestapelten Aktor 600'. In der Figur 6c ist insbesondere eine alternative Kontaktierungsmöglichkeit der Elektroden dargestellt. So kann in diesem Fall die Vereinzelungsstation 7 der Kontaktierungsstation 6 vorgelagert sein. Die Vereinzelungsstation 7 kann insbesondere mittels Ultraschallschneiden die Stapelaktoren derart vereinzeln, dass die Stirnkanten der Elektroden 601, insbesondere die Stirnflächen der Anschlusskontaktflächen 602.1', 602.2' freiliegen und kontaktiert werden können. Beispielsweise kann eine Nut 605.1, 605.2 mit einer leitfähigen Paste gefüllt werden. Es versteht sich, dass auf die Herstellung einer Nut 605.1, 605.2 verzichtet werden kann.

Vorzugsweise können die elektrischen Kontakte angegossen werden. Diese Art der Kontaktierung besitzt den Vorteil, dass auf eine aufwendige Herstellung von Hohlräumen verzichtet werden kann.

Nach der Vereinzelung und Kontaktierung der Stapelaktoren können die Stapelaktoren der Verkapselungsstation 8 zugeführt werden. Die Verkapselungsstation 8 ist dazu eingerichtet, die Stapelaktoren in einem Verkapselungsschritt 109 zu verkapseln.

In diesem Schritt 109 werden die Stapelaktoren verkapselt. Mögliche Materialien, die für die Verkapselung in Frage kommen, sind Silikon oder Polyurethan. Ein Silikon hat eher feuchtigkeitsabweisende Eigenschaften als PU, doch das PU wird eine monolithische Verbindung mit dem Aktor eingehen, so dass es nur zu geringe Verluste bei Übertragung der Kraft führen wird. Wichtig hierbei ist, dass das eingesetzte Material einen sehr niedrigen E-Modul aufweist, so dass die Auslenkung des Aktors nicht verhindert wird. Weiterer Vorteil der Verkapselung ist, dass der Bereich der inaktiven Fläche verringert werden kann. Die hier erwähnten Materialien weisen isolierende Eigenschaften auf, so dass es zu keinen Spannungsüberschlägen kommt. Auch kann die mechanische Anbindung direkt mit eingegossen werden.

Weiterer Vorteil des Eingießens ist ein Verhindern des Delaminierens des Stapelaktors im inaktiven Randbereich. Im Randbereich kann es bei einem aktivierten Stapelaktor und der damit verbundenen Ausdehnung des aktiven Aktorbereiches zu Spannungsinhomogenitäten kommen, wie der Figur 8 entnommen werden kann. Durch das Eingießen werden die einzelnen Folienschichten zusammengehalten und ein Delaminieren der Schichten verhindert.

Auch in dem hier beschriebenen Prozess werden mehrere Stapelaktoren gleichzeitig verkapselt. In einer Form werden z.B. mehrere Stapelaktoren positioniert. Die Form wird mit einem 2K-Dosiersystem, z.B. von der Firma Vieweg, befüllt.

## Patentansprüche

1. Verfahren zum Herstellen eines Elastomer basierten Folienstapelaktors, umfassend:
a) einen Startprozess mit den Schritten:
a1) Bereitstellen einer Elastomer-Folie (200) mit einer Elastomer-Schicht (202) und zwei Deckschichten (201, 203) in Form einer Kaschierungsschicht (201) und einer Linerschicht. (203), und
a2) Entfernen von einer der zwei Deckschichten (201, 203) von der Elastomer-Folie (200) zur Herstellung einer dekaschierten Folienanordnung,
b) einen dem Startprozess nachfolgenden Stapelprazess mit den Schritten:
b1) Aufbringen einer Schicht von Elektroden (301, 601) auf die Elastomer-Schicht (202) der dekaschierten Folienanordnung,
b2) Auflaminieren einer weiteren dekaschierten Elastomer-Folie (401) auf die mit Elektroden (301, 601) versehene Folienanordnung, und
b3) Entfernen von einer der zwei Deckschichten von der laminierten Folienanordnung zur Herstellung einer dekaschierten Folienanordnung,
wobei in dem Stapelprozess b) die Schritte b1) bis b3) mindestens einmal wiederholt werden,
wobei die Elektroden (301, 601) in aufeinander folgenden alternierenden Schritten b1) jeweils mit einem Versatz zwischen 0,2 mm und 2,0 mm aufgebracht werden, und
wobei dem wiederholten Schritt b1) die in dem vorherigen Schritt b3) erzeugte dekaschierte Folienanordnung als dekaschierte Folienanordnung bereitgestellt wird,
c) einen dem Stapelprozess nachfolgenden Finalisierungsprozess mit den Schritten:
c1) Kontaktieren der Elektroden (301, 601) der durch den Stapelungsprozess erzeugten Folienanordnung,
c2) Vereinzeln von Stapelaktoren der durch den Stapelungsprozess erzeugten Folienanordnung, und
c3) Verkapseln der vereinzelten Stapelaktoren.

2. Verfahren nach Anspruch 1, **dadurch gekennzeichnet, dass** in einem Schritt a3) des Startprozesses a) die Elastomer-Folie (200) zugeschnitten wird.

3. Verfahren nach Anspruch 1 oder 2, **dadurch gekennzeichnet, dass**
- das Aufbringen der Elektroden (301, 601) auf die Elastomer-Schicht (202) ein Aufbringen von strukturierten Elektroden (301, 601) umfasst,
- wobei die strukturierten Elektroden (301, 601) durch einen Siebdruckprozess, einen Tiefdruckprozess, einen Flexodruckprozess und/oder ein Sprühverfahren aufgebracht werden.

4. Verfahren nach einem der vorherigen Ansprüche, **dadurch gekennzeichnet, dass**
- das Kontaktieren der Elektroden (301, 601) das Erzeugen von Hohlräumen (604.1, 604.2) an oder in Anschlusskontaktflächen (602.1, 602.2) der Elektroden (301, 601) umfasst, und
- die Hohlräume (604.1, 604.2) zur Kontaktierung der Elektroden (301, 601) mit einer leitfähigen Paste gefüllt werden.

5. Verfahren nach Anspruch 4, **dadurch gekennzeichnet, dass** die leitfähige Paste zumindest aus einem chemisch ähnlichen Material wie der Stapelaktor, vorzugsweise aus dem gleichen Material wie der Stapelaktor, gebildet ist.

6. Verfahren nach einem der vorherigen Ansprüche 1 bis 3, **dadurch gekennzeichnet, dass**
- die Stapelaktoren vereinzelt werden, derart, dass Stirnflächen der Anschlusskontaktflächen (602.1', 602.2') der Elektroden (301, 601) freiliegen, und
- an die freiliegenden Anschlusskontaktflächen (602.1', 602.2') ein elektrischer Leiter zur Kontaktierung der Elektroden (301, 601) angebracht wird.

7. Verfahren nach Anspruch 6, **dadurch gekennzeichnet, dass** der elektrische Leiter mittels eines Siebdruckprozesses angegossen wird.

8. Verfahren nach einem der vorherigen Ansprüche, **dadurch gekennzeichnet, dass**
- das Vereinzeln der Stapelaktoren mittels eines Ultraschallprozesses durchgeführt wird, und/oder
- das Zuschneiden der Elastomerfolie (200) mittels eines Ultraschallprozesses durchgeführt wird.

9. Verfahren nach einem der vorherigen Ansprüche, **dadurch gekennzeichnet, dass** die vereinzelten Stapelaktoren durch Eingießen mit einem ein niedriges E-Modul aufweisenden Material, insbesondere Silikon oder Polyurethan, verkapselt werden.

10. Elastomer basierter Folienstapelaktor hergestellt durch ein Verfahren gemäß einem der vorherigen Ansprüche.

11. Vorrichtung (100) zum Herstellen eines Elastomer basierten Folienstapelaktors, umfassend:
a) eine Startprozessanordnung (10) mit:
- einer ersten Dekaschierungsstation (2) eingerichtet zum Entfernen einer Deckschicht (201, 203) von einer bereitgestellten Elastomer-Folie (200) zur Herstellung einer dekaschierten Folienanordnung,
- wobei die bereitgestellte Elastomer-Folie (200) eine Elastomer-Schicht (202) und zwei Deckschichten (201, 203) in Form einer Kaschierungsschicht (201) und einer Linerschicht (203) umfasst,
b) eine der Startprozessanordnung (10) nachfolgende Stapelprozessanordnung (20) mit:
- einer Aufbringstation (3) eingerichtet zum Aufbringen einer Schicht von Elektroden (301, 601) auf die Elastomer-Schicht (202) der dekaschierten Folienanordnung,
- einer Laminierungsstation (4, 400) eingerichtet zum Auflaminieren einer weiteren dekaschierten Elastomer-Folie (401) auf die mit Elektroden (301, 601) versehene Folienanordnung, und
- einer zweiten Dekaschierungsstation (5) eingerichtet zum Entfernen von einer von zwei Deckschichten von der laminierten Folienanordnung zur Herstellung einer dekaschierten Folienanordnung,
- wobei die Stapelprozessanordnung (20) eingerichtet ist, die durch die zweite Dekaschierungsstation (5) erzeugte dekaschierte Folienanordnung entweder der Aufbringstation (3) oder einer nachfolgenden Finalisierungsprozessanordnung (30) zuzuführen,
c) die der Stapelprozessanordnung (20) nachfolgende Finalisierungsprozessanordnung (30) mit:
- einer Kontaktierungsstation (6) eingerichtet zum Kontaktieren der Elektroden (301, 601) der durch die zweite Dekaschierungsstation (5) erzeugten dekaschierten Folienanordnung,
- einer Vereinzelungsstation (7) eingerichtet zum Vereinzeln von Stapelaktoren der durch die zweite Dekaschierungsstation (5) erzeugten dekaschierten Folienanordnung, und
- einer Verkapselungsstation (8) eingerichtet zum Verkapseln der vereinzelten Stapelaktoren.

12. Vorrichtung (100) nach Anspruch 11, **dadurch gekennzeichnet, dass** die Startprozessanordnung (10) eine Zuschnittstation (1) eingerichtet zum Zuschneiden der bereitgestellten Elastomer-Folie (200) oder der dekaschierten Folienanordnung umfasst.

13. Vorrichtung (100) nach Anspruch 11 oder 12, **dadurch gekennzeichnet, dass**
- die Kontaktierungsstation (6) eine Kontaktierungseinrichtung (700) zum Kontaktieren der Elektroden (301, 601) aufweist,
- die Kontaktierungseinrichtung (700) ein Absaugteil (701) eingerichtet zum Absaugen des bei der Erzeugung eines Hohlraums (604.1, 604.2) entstehenden Butzens aufweist, und
- die Kontaktierungseinrichtung (700) ein Zuleitungsteil (702) eingerichtet zum Dosieren der leitfähigen Paste in den erzeugten Hohlraum (604.1, 604.2) aufweist.

## Claims

1. A method for producing an elastomer-based film-stack actuator, comprising:
a) a starting process with the steps of:
a1) preparing an elastomeric film (200) with an elastomeric layer (202) and two covering layers (201, 203) in the form of a lamination layer (201) and a liner layer (203) and
a2) removing one of the two covering layers (201, 203) from the elastomeric film (200) for producing a delaminated film arrangement,
b) a stacking process, following the starting process, with the steps of:
b1) applying a layer of electrodes (301, 601) on the elastomeric layer (202) of the delaminated film arrangement,
b2) laminating a further delaminated elastomeric film (401) on the film arrangement, which has been provided with electrodes (301, 601), and
b3) removing one of the two covering layers from the laminated film arrangement for producing a delaminated film arrangement,
wherein the steps b1) to b3) are repeated at least once in the stacking process b),
wherein the electrodes (301, 601) are applied in consecutive, alternating steps b1) with an offset of between 0.2 mm and 2.0 mm and
wherein the delaminated film arrangement, produced in the previous step b3), is made available to the repeated step b1) as a delaminated film arrangement,
c) a finalizing process, following the stacking process, with the steps of:
c1) contacting the electrodes (301, 601) of the film arrangement, produced by the stacking process,
c2) separating stacking actuators of the film arrangement, produced by the stacking process, and
c3) encapsulating the separated stacking actuators.

2. The method according to claim 1, **characterized in that** the elastomeric film (200) is customized in a step a3) of the starting process a).

3. The method according to claim 1 or 2, **characterized in that**
- the application of the electrodes (301, 601) on the elastomeric layer (202) comprises an application of structured electrodes (301, 601,
- wherein the structured electrodes (301,601) are applied by a screen printing process, a gravure printing process, a flexographic printing process and / or a spraying process.

4. The method according to one of the preceding claims, **characterized in that**
- the contacting of the electrodes (301, 601) comprises producing cavities (604.1, 604.2) at or in connecting, contacting areas (602.1, 602.2) of the electrodes (301, 601) and
- the cavities (604.1, 604.2) for contacting the electrodes (301, 601) are filled with a conductive paste.

5. The method according to claim 4, **characterized in that** the conductive paste is formed from a similar material, which is at least chemically similar to that of the stacking actuator or preferably is formed from the same material as the stacking actuator.

6. The method according to one of the preceding claims 1 to 3, **characterized in that**
- the stacking actuators are separated in such a way that the end faces of the connecting contact surfaces (602.1', 602.2') of the electrodes (301, 601) are exposed, and
- an electrical conductor for contacting the electrodes (301, 601) is attached to the exposed connecting, contact surfaces (602.1', 602.2').

7. The method according to claim 6, **characterized in that** the electric conductor is cast by means of a screen printing process.

8. The method according to one of the preceding claims, **characterized in that**
- the separation of the stack actuator is carried out by means of an ultrasonic process, and/or
- the elastomeric film (200) is customized by means of an ultrasonic process.

9. The method according to one of the preceding claims, **characterized in that** the separated stack actuators are encapsulated by casting them in a material having a low modulus of elasticity, especially in a silicone or a polyurethane.

10. An elastomer-based film stack actuator, produced by a method according to one of the preceding claims.

11. A device (100) for producing an elastomer-based film-stack actuator, comprising:
a) a starting process assembly (10) with
- a first delamination station (2), which is set up to remove a covering layer (201, 203) from a provided elastomeric film (200) for producing a delaminated film assembly,
- wherein the prepared elastomeric film (200) comprises an elastomeric layer (202) and two covering layers (201, 203) in the form of a lamination layer (201) and a liner layer (203),
b) a stacking process arrangement (20) following the starting process arrangement (10) with:
- an application station (3), which is set up for applying a layer of electrodes (301, 601) on the elastomeric lead (202) of the delaminated film arrangement,
- a lamination station (4, 400) set up for laminating a further delaminated elastomeric film (401) on the film arrangement, which is provided with electrodes (301, 601), and
- a second delamination station (5), which is set up for removing one of two covering layers from the laminated film arrangement for producing a delaminated film arrangement,
- wherein the stacking process arrangement (20) is set up to supply the delaminated film arrangement, which is produced by the second delamination station (5), either to the application station (3) or to a subsequent finalization process arrangement (30),
c) the finalizing process arrangement, which follows the stacking process arrangement (20) with:
- a contact-making station (6) adapted to contact the electrodes (301, 601) of the delaminated film arrangement, which is produced by the second delamination station (5),
- a separating station (7), which is set up for separating stack actuators of the delaminated film arrangement, produced by the second delaminating station (5), and
- an encapsulating station (8), which is set up for encapsulating the separated stack actuators.

12. The device (100) according to claim 11, **characterized in that** the start the process arrangement (10) comprises a customizing station (1), which is set up for customizing the provided elastomeric film (200) or the delaminated film arrangement.

13. The device (100) according to claim 11 or 12, **characterized in that**
- the contacting station (6) has a contacting device (700) for contacting the electrodes (301, 601),
- the contacting device (700) has a suction part (701) for aspirating the scrap, which results during the production of a cavity (604.1, 604.2), and
- the contacting device (700) has a supply line (702), which is set up for metering out the conductive paste into the cavity (604.1, 604.2), which has been produced.

## Revendications

1. Procédé de fabrication d'un actionneur d'empilage de feuilles à base d'élastomère, comprenant :
a) un processus de démarrage comprenant les étapes consistant :
a1) à fournir une feuille d'élastomère (200) comprenant une couche d'élastomère (202) et deux couches de recouvrement (201, 203) se présentant sous la forme d'une couche de pelliculage (201) et d'une couche de doublage (203), et
a2) à éliminer l'une des deux couches de recouvrement (201, 203), de la feuille d'élastomère (200), dans le but de produire un agencement de feuilles dépelliculées,
b) un processus d'empilage qui fait suite au processus de démarrage et qui comprend les étapes consistant :
b1) à appliquer une couche d'électrodes (301,601) sur la couche d'élastomère (202) de l'agencement de feuilles dépelliculées,
b2) à appliquer par lamination une autre feuille d'élastomère dépelliculée (401) sur l'agencement de feuilles doté des électrodes (301, 601), et
b3) à éliminer l'une des deux couches de recouvrement, de l'agencement de feuilles laminées, dans le but de produire un agencement de feuilles dépelliculées,
où au cours du processus d'empilage b), les étapes b1) à b3) sont répétées au moins une fois,
où les électrodes (301, 601), au cours d'étapes b1) qui se suivent de manière alternée, sont appliquées en ayant à chaque fois un décalage compris entre 0,2 mm et 2,0 mm, et
où l'agencement de feuilles dépelliculées produit au cours de l'étape précédente b3), comme agencement de feuilles dépelliculées, est fourni à l'étape répétée b1),
c) un processus de finalisation qui fait suite au processus d'empilage et qui comprend les étapes consistant :
c1) à mettre en contact les électrodes (301, 601) de l'agencement de feuilles produit par le processus d'empilage,
c2) à séparer des actionneurs d'empilage de l'agencement de feuilles produit par le processus d'empilage, et
c3) à encapsuler les actionneurs d'empilage séparés.

2. Procédé selon la revendication 1, **caractérisé en ce que** la feuille d'élastomère (200) est coupée à dimensions au cours d'une étape a3) du processus de démarrage a).

3. Procédé selon la revendication 1 ou 2, **caractérisé**
- **en ce que** l'application des électrodes (301, 601) sur la couche d'élastomère (202) comprend une application d'électrodes structurées (301, 601),
- où les électrodes structurées (301, 601) sont appliquées par un processus de sérigraphie, par un processus d'héliogravure, par un processus de flexographie et/ou par un procédé réalisé par pulvérisation.

4. Procédé selon l'une quelconque des revendications précédentes, **caractérisé**
- **en ce que** la mise en contact des électrodes (301, 601) comprend la réalisation d'espaces creux (604.1, 604.2) sur ou dans des surfaces de contact de connexion (602.1, 602.2) des électrodes (301, 601), et
- **en ce que** les espaces creux (604.1, 604.2) servant à la mise en contact des électrodes (301, 601) sont remplis d'une pâte conductrice.

5. Procédé selon la revendication 4, **caractérisé en ce que** la pâte conductrice est formée en étant composée au moins d'une matière chimiquement semblable à celle de l'actionneur d'empilage, de préférence en étant composée de la même matière que celle de l'actionneur d'empilage.

6. Procédé selon l'une quelconque des revendications 1 à 3, **caractérisé**
- **en ce que** les actionneurs d'empilage sont séparés de manière telle, que des surfaces frontales des surfaces de contact de connexion (602.1', 602.2') des électrodes (301, 601) soient dégagées, et
- **en ce qu'**un conducteur électrique servant à la mise en contact des électrodes (301, 601) est appliqué aux surfaces de contact de connexion dégagées (602.1', 602.2').

7. Procédé selon la revendication 6, **caractérisé en ce que** le conducteur électrique est moulé au moyen d'un processus de sérigraphie.

8. Procédé selon l'une quelconque des revendications précédentes, **caractérisé**
- **en ce que** la séparation des actionneurs d'empilage est réalisée au moyen d'un processus par ultrasons, et/ou
- **en ce que** la découpe, à dimensions, de la feuille d'élastomère (200) est réalisée au moyen d'un processus par ultrasons.

9. Procédé selon l'une quelconque des revendications précédentes, **caractérisé en ce que** les actionneurs d'empilage séparés sont encapsulés par moulage, avec un matériau présentant un module de faible élasticité, en particulier un matériau tel que du silicone ou du polyuréthane.

10. Actionneur d'empilage de feuilles à base d'élastomère fabriqué par un procédé selon l'une quelconque des revendications précédentes.

11. Dispositif (100) servant à la fabrication d'un actionneur d'empilage de feuilles à base d'élastomère, ledit dispositif comprenant :
a) un agencement de processus de démarrage (10) comprenant :
- un premier poste de dépelliculage (2) mis en place dans le but d'éliminer une couche de recouvrement (201, 203), d'une feuille d'élastomère fournie (200), dans le but de produire un agencement de feuilles dépelliculées,
- où la feuille d'élastomère fournie (200) comprend une couche d'élastomère (202) et deux couches de recouvrement (201, 203) se présentant sous la forme d'une couche de pelliculage (201) et d'une couche de doublage (203),
b) un agencement de processus d'empilage (20) qui fait suite à l'agencement de processus de démarrage (10) et qui comprend :
- un poste d'application (3) mis en place dans le but appliquer une couche d'électrodes (301, 601) sur la couche d'élastomère (202) de l'agencement de feuilles dépelliculées,
- un poste de lamination (4, 400) mis en place dans le but d'appliquer par lamination une autre feuille d'élastomère dépelliculée (401), sur l'agencement de feuilles doté des électrodes (301, 601), et
- un second poste de dépelliculage (5) mis en place dans le but d'éliminer l'une des deux couches de recouvrement, de l'agencement de feuilles laminées, dans le but de produire un agencement de feuilles dépelliculées,
- où l'agencement de processus d'empilage (20) est mis en place pour fournir l'agencement de feuilles dépelliculées, produit par le second poste de dépelliculage (5), soit au poste d'application (3) soit à un agencement de processus de finalisation (30) qui fait suite,
c) l'agencement de processus de finalisation (30) qui fait suite à l'agencement de processus d'empilage (20) et qui comprend :
- un poste de mise en contact (3) mis en place dans le but de mettre en contact les électrodes (301, 601) de l'agencement de feuilles dépelliculées produit par le second poste de dépelliculage (5),
- un poste de séparation (7) mis en place dans le but de séparer des actionneurs d'empilage de l'agencement de feuilles dépelliculées produit par le second poste de dépelliculage (5), et
- un poste d'encapsulage (8) mis en place dans le but d'encapsuler les actionneurs d'empilage séparés.

12. Dispositif (100) selon la revendication 11, **caractérisé en ce que** l'agencement de processus de démarrage (10) comprend un poste de découpe à dimensions (1) mis en place dans le but de découper à dimensions la feuille d'élastomère fournie (200) ou l'agencement de feuilles dépelliculées.

13. Dispositif (100) selon la revendication 11 ou 12, **caractérisé**
- **en ce que** le poste de mise en contact (6) présente un dispositif de mise en contact (700) servant à la mise en contact des électrodes (301, 601),
- **en ce que** le dispositif de mise en contact (700) présente une partie d'aspiration (701) mise en place dans le but d'aspirer des débris se produisant lors de la réalisation d'un espace creux (604.1, 604.2), et
- **en ce que** le dispositif de mise en contact (700) présente une partie d'alimentation (702) mise en place dans le but de doser la pâte conductrice contenue dans l'espace creux réalisé (604.1, 604.2).
